# FASCICULE DE BREVET EUROPEEN

(11) **EP 3 328 059 B1**
(45) Date de publication et mention de la délivrance du brevet: **18.03.2020**
(21) Numéro de dépôt: 17200738.7
(22) Date de dépôt: 09.11.2017
(51) Int. Cl.: B60R 11/00, B60R 11/04, H04N 5/225, H05K 1/14, H05K 3/36

(54) **DISPOSITIF DE CAMERA D'UN VEHICULE AUTOMOBILE ET METHODE D'ASSEMBLAGE**
KAMERAVORRICHTUNG EINES KRAFTFAHRZEUGS, UND MONTAGEMETHODE
CAMERA DEVICE OF A MOTOR VEHICLE AND METHOD OF ASSEMBLY

(30) Priorité: 25.11.2016 FR 1661502
(43) Date de publication de la demande: 30.05.2018
(73) Titulaire: Aptiv Technologies Limited, St. Michael (BB)
(72) Inventeur: ZUROWSKI, Miroslaw J., 30-348 Krakow (PL); JARCZOK, Slawomir, 30-348 Krakow (PL); ANTOS, Przemmyslaw, 32-050 Skawina (PL)
(74) Mandataire: Vigand, Philippe

(56) Documents cités:
- WO-A1-2013/123161
- GB-A- 2 527 117

## Description

### DOMAINE TECHNIQUE

La présente invention concerne un dispositif de caméra pour surveiller le champ de vision avant d'un véhicule automobile.

### ARRIERE-PLAN TECHNOLOGIQUE DE L'INVENTION

Dans les véhicules, les dispositifs de caméras sont généralement installés sur le pare-brise, à proximité du miroir central, dans la partie milieu supérieure du pare-brise. Un tel emplacement permet un champ de vision large et non perturbé pour le système.

Les dispositifs de caméra comportent généralement une partie module de caméra comprenant la lentille et le capteur d'image de la caméra, le module étant agencé sur une première carte à circuit imprimé de sorte que l'axe optique de la lentille est perpendiculaire à la carte à circuit imprimé. Les dispositifs de caméra comportent généralement également une partie traitement d'image et interface avec le véhicule agencée sur une seconde carte à circuit imprimé.

L'une des exigences les plus courantes pour ces dispositifs de caméra est d'avoir un axe optique principal parallèle à l'axe longitudinal du véhicule.

En raison de cette exigence, la carte à circuit imprimé est disposée perpendiculaire à l'axe longitudinal du véhicule de manière à ce que l'axe optique de la caméra soit parallèle à l'axe longitudinal du véhicule.

Le traitement d'images des systèmes de caméra est réalisé sur une carte à circuit imprimé beaucoup plus grande et complexe que la carte à circuit imprimé comprenant le capteur d'image. La tendance des exigences d'intégration est à la réduction de taille des systèmes à caméra embarquée.

Il est connu de concevoir des systèmes de caméra pour lesquels la carte à circuit imprimé, sur laquelle le traitement d'image est effectué, est agencée de manière inclinée jusqu'à quelques dizaine de degrés selon l'axe longitudinal du véhicule. Cela conduit généralement à connecter la carte à circuit imprimé comportant le capteur d'image à la carte à circuit imprimé réalisant le traitement d'image par une nappe électrique souple. Un tel assemblage de trois éléments dans un environnement réduit est une opération complexe et couteuse.

A titre d'exemple, le document WO 2013/123161 A1 propose un système de vision ou d'imagerie pour véhicule qui utilise une caméra disposée sur une carte imprimée secondaire qui est connectée à une carte principale par une telle nappe électrique souple.

Il est donc important de proposer une solution nouvelle résolvant ces problèmes.

### RESUME DE L'INVENTION

Un dispositif de caméra comprend une carte mère globalement rectangulaire, une carte fille comprenant un module de caméra dont l'axe optique est perpendiculaire au plan principal de la carte fille. La carte mère comporte une section principale rigide comprenant des composants électroniques de traitement d'images. La carte mère comporte une section secondaire venue de matière avec la section principale. La section secondaire est partiellement entourée d'un évidement. La section secondaire a une frontière rectiligne délimitant la jonction entre la section principale et la section secondaire, la frontière rectiligne définissant un axe de pivotement de la section secondaire. La section secondaire comprend une section de connexion et une section intermédiaire s'étendant entre la frontière rectiligne et la section de connexion, la section intermédiaire étant d'épaisseur réduite par rapport à une épaisseur de la section principale. La carte fille est montée perpendiculairement sur la section secondaire. Ainsi, la section secondaire est inclinable relativement à la surface de la section principale selon l'axe de pivotement afin de pouvoir ajuster l'angle d'inclinaison entre l'axe optique du module de caméra et la section principale.

De préférence, l'axe optique peut être perpendiculaire à l'axe de pivotement. L'inclinaison de la section secondaire par rapport à la section principale peut être facilitée notamment lorsque la carte fille est agencée sur la section de connexion. La section intermédiaire peut également avoir une épaisseur réduite par rapport à l'épaisseur de la section de connexion.

De préférence, la section secondaire peut être délimitée par au moins une fente s'étendant depuis un bord rectiligne de la carte mère jusqu'à l'axe de pivotement de la section secondaire. La section secondaire peut être délimitée par deux fentes de part et d'autre de la section secondaire, les deux fentes s'étendant depuis le bord rectiligne de la carte mère jusqu'à l'axe de pivotement de la section secondaire.

Le dispositif de caméra peut être configuré pour être monté dans le compartiment passager d'un véhicule, sur le pare-brise du véhicule. Le dispositif de caméra peut comporter un ensemble boîtier comprenant une paroi de fond et un capot supérieur. La carte mère peut être fixée à plat sur la paroi de fond du boîtier. Le module de caméra peut être fixé sur le capot supérieur. Ainsi, la section secondaire de la carte mère est inclinée d'un angle α relativement à la surface de la section principale selon l'axe de pivotement.

Une méthode d'assemblage d'un dispositif de caméra comporte les étapes de :
fourniture d'une carte mère globalement rectangulaire comportant une section principale rigide et une section secondaire partiellement entourée d'un évidement et ayant une frontière rectiligne délimitant une jonction entre la section principale et la section secondaire, la frontière rectiligne définissant un axe de pivotement de la section secondaire de manière que la section secondaire soit inclinable relativement à la surface de la section principale selon l'axe de pivotement;
réalisation d'une section de connexion et d'une section intermédiaire sur la section secondaire prévue pour connecter une carte fille, la section intermédiaire s'étendant entre la frontière rectiligne et la section de connexion et étant d'épaisseur réduite par rapport à une épaisseur de la section principale;
fourniture d'une carte fille comprenant un module de caméra dont l'axe optique est perpendiculaire au plan principal de la carte fille;
fourniture d'un ensemble boîtier comportant un capot supérieur et un boitier inférieur;
fixation du module de caméra sur le capot supérieur;
assemblage de la carte mère sur la carte fille par connexion de la carte fille orthogonalement sur la section de connexion;
assemblage du boîtier inférieur avec le capot supérieur de sorte à fermer l'ensemble boîtier;
fixation à plat de la carte mère sur la paroi de fond du boîtier inférieur, l'axe optique du module de caméra s'inclinant d'un angle α relativement à la surface de la section principale de la carte mère.

De préférence, les étapes de fixation de la carte mère et du module de caméra peuvent se faire par vissage.

### BREVE DESCRIPTION DES DESSINS

D'autres caractéristiques, buts et avantages de l'invention apparaîtront à la lecture de la description détaillée qui va suivre, et en regard des dessins annexés, donnés à titre d'exemple non limitatif et sur lesquels:
- La figure 1 est une vue schématique d'un véhicule équipé du dispositif de caméra selon l'invention.
- La figure 2 est une vue schématique par transparence du dispositif de caméra selon l'invention fixé sur le pare-brise d'un véhicule.
- La figure 3 est une vue schématique en perspective de la carte mère du dispositif de caméra selon l'invention.
- La figure 4 est une vue schématique en coupe selon un axe vertical de la carte fille assemblée avec la carte mère selon l'invention.
- La figure 5 est une vue schématique éclatée du dispositif de caméra.

### DESCRIPTION DES MODES DE REALISATION PREFERES

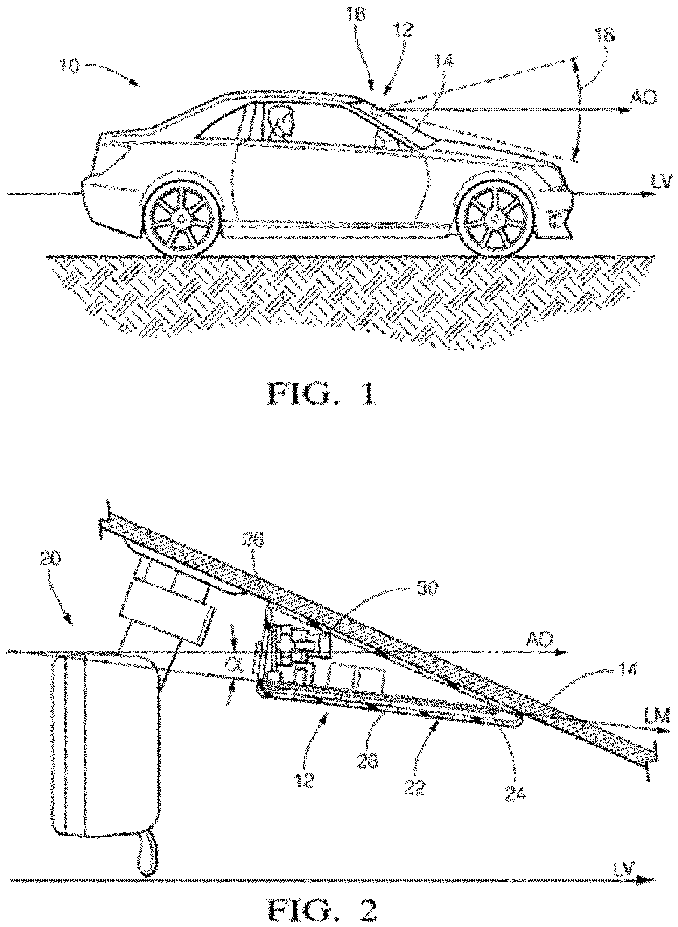

Selon la figure 1, un véhicule 10 est équipé d'un ensemble d'imagerie, ci-après dénommé un dispositif de caméra 12, adapté pour capturer une image d'un champ de vision 18 à proximité du véhicule 10. Dans cet exemple le dispositif de caméra 12 est représenté comme étant monté derrière le pare-brise 14 du véhicule 10. Le dispositif de caméra 12 comprend un module de caméra 16 configurée pour capturer une image du champ de vision 18 du véhicule 10 à travers une partie du pare-brise 14. Le champ de vision 18 du véhicule 10 s'étend horizontalement vers l'avant du véhicule 10, suivant l'axe optique principal AO de la caméra. L'axe optique AO est globalement parallèle à l'axe longitudinal du véhicule LV. On entend par axe longitudinal du véhicule LV, l'axe selon lequel le véhicule 10 s'étend de l'arrière vers l'avant et globalement parallèle à une route plane sur laquelle repose le véhicule 10. Ce dispositif de caméra 12 permet en outre de détecter, de façon non limitative, les voies routières, les panneaux indicateurs, la signalisation routière, les obstacles, les piétons....

Selon la figure 2, le dispositif de caméra 12 est agencé vers l'avant dans le véhicule 10. Plus particulièrement, le dispositif de caméra 12 est agencé dans la partie milieu supérieure du pare-brise 14, devant le rétroviseur intérieur 20 du véhicule 10, de sorte que le champ de vision 18 est vers l'avant du véhicule 10. Le dispositif de caméra 12 comporte un ensemble boîtier 22 fixé au pare-brise 14, par l'intermédiaire par exemple d'un châssis ou un support qui est fixé par un adhésif au pare-brise 14 ou d'éléments de fixation.

Le dispositif de caméra 12 comprend une première carte à circuit imprimé, dénommée carte mère 24, et une seconde carte à circuit imprimé, dénommée carte fille 26. La carte mère 24 est agencée à plat sur une paroi de fond 28 de l'ensemble boîtier 22 selon un axe longitudinal dénommé axe longitudinal de la carte mère LM. La carte fille 26 est agencée sur la carte mère 24 de manière à être perpendiculaire à l'axe longitudinal du véhicule LV.

La carte fille 26 est équipée du module de caméra 16 comprenant l'objectif de la caméra 30. La particularité de l'invention réside dans le fait que l'axe optique AO de l'objectif 30 du module de caméra 16 est parallèle à l'axe longitudinal du véhicule LV alors que la carte mère 24 présente une inclinaison d'un angle α suivant l'axe longitudinal du véhicule LV. Autrement dit, l'axe optique AO présente une inclinaison d'un angle α avec l'axe longitudinal de la carte mère LM.

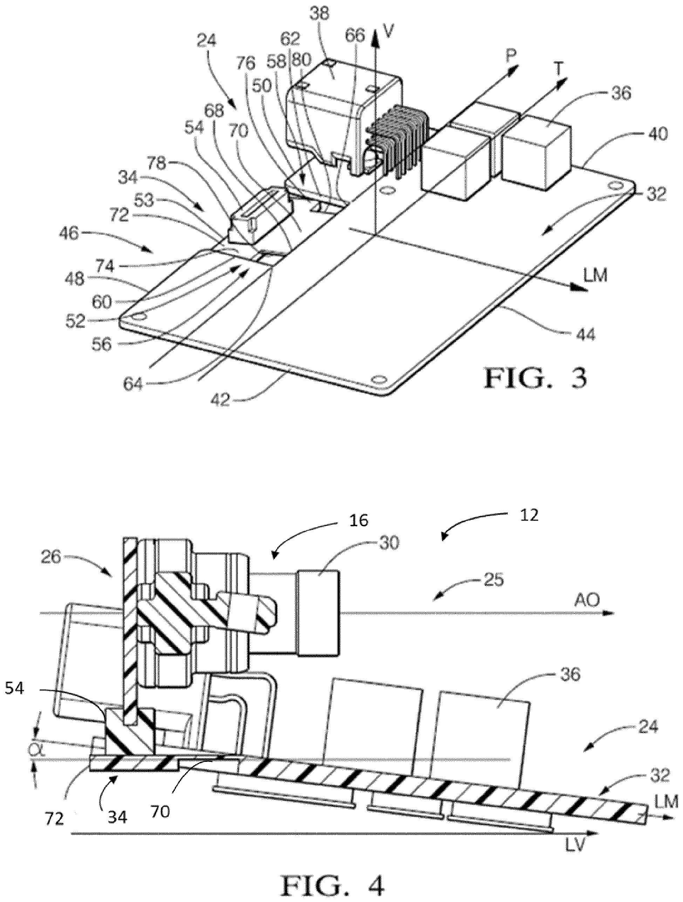

Selon la figure 3, la carte mère 24, de forme globalement rectangulaire, comprend une section principale 32 et une section secondaire 34. La carte mère 24 est donc une unique carte à circuit imprimé pour laquelle la section secondaire 34 est venue de matière avec la section principale 32.

La section principale 32 est la section de plus grande surface sur laquelle sont agencés des composants électroniques 36 permettant le traitement d'images capturées par le module de caméra 16. La section principale 32 est également équipée d'un connecteur 38 permettant de raccorder électriquement le dispositif de caméra 12 au réseau électrique du véhicule 10 et donc notamment à des systèmes de sécurité du véhicule 10 tel que par exemple au système de freinage d'urgence. La section principale 32 est de forme globalement rectangulaire. La section principale 32 comprend donc deux bordures parallèles 40, 42 s'étendant selon l'axe longitudinal de la carte mère LM et également deux autres bordures 44, 46 s'étendant selon un axe transversal T perpendiculaire à l'axe longitudinal de la carte mère LM. Une des deux bordures transversales 46 de la section principale 32 comprend une discontinuité séparant cette bordure 46 en une première section de bordure 48 et une deuxième section de bordure 50. La discontinuité est une encoche 52 également de forme globalement rectangulaire.

La section secondaire 34 est agencée dans l'encoche 52. La section secondaire 34 comprend une bordure transversale 53 alignée transversalement avec la première section de bordure 48 et la deuxième section bordure 50. Un connecteur à angle droit 54 prévu pour recevoir la carte fille 26 est agencé parallèlement et à proximité de la bordure transversale 53 de la section secondaire 34. La section secondaire 34 est délimitée de part et d'autre par une première fente 56 et une deuxième fente 58 s'étendant depuis la bordure transversale 53 de la section secondaire 34 sur chaque côté du connecteur à angle droit 54 jusqu'à une première extrémité 64 et une deuxième extrémité 66. La première extrémité 64 et la deuxième extrémité 66 sont équidistantes de la bordure transversale 53 de la section secondaire 34. La première fente 56 et la deuxième fente 58 sont globalement perpendiculaires à la bordure transversale 53 de la section secondaire 34. Une frontière rectiligne 68 s'étendant depuis la première extrémité 64 jusqu'à la deuxième extrémité 66 délimite également la section secondaire 34 de la section principale 32. La frontière rectiligne 68 est parallèle à la bordure transversale 53 de la section secondaire 34.

La première fente 56 et la deuxième fente 58 s'étendent perpendiculairement à la première section de bordure 48 et à la deuxième section de bordure 50 de sorte à former deux autres bordures sur la section principale 32. On nommera ces deux bordures, les bordures internes 60, 62 de la section principale 32. La première fente 56 et la deuxième fente 58 sont de longueur similaire selon l'axe longitudinal de la carte mère LM.

En d'autres termes, cela signifie que la section secondaire 34 est une section de la carte mère 24 entourée partiellement d'un évidement. L'évidement incluant la première fente 56 et la deuxième fente 58, ainsi que l'espace libre en dehors de la surface de la carte mère 24. La frontière rectiligne 68 définie une jonction entre la section principale 32 et la section secondaire 34.

Telle que représentée, l'évidement et la frontière rectiligne 68 permettent à la section secondaire 34 d'être inclinable. Plus précisément, la section secondaire 34 est inclinée relativement à la surface de la section principale 32 selon un axe de pivotement P. La frontière rectiligne 68 définit l'axe de pivotement P de la section secondaire 34 permettant ainsi son inclinaison. La possible inclinaison de la section secondaire 34 est prévue pour ajuster l'inclinaison de l'axe optique AO du module de caméra 16 lorsque la carte fille 26 est montée sur le connecteur à angle droit 54.

Egalement, selon la figure 3, la section secondaire 34 comprend une section intermédiaire 70 et une section de connexion 72. La section intermédiaire 70 et la section de connexion 72 s'étendent l'une à la suite de l'autre respectivement depuis la frontière rectiligne 68 jusqu'à la bordure transversale 53 de la section secondaire 34. La section intermédiaire 70, de forme globalement rectangulaire, est donc la partie de la section secondaire 34 comprise entre la section de connexion 72 et la frontière rectiligne 68.

La section de connexion 72, de forme globalement rectangulaire, comporte le connecteur à angle droit 54 prévu pour recevoir la carte fille 26. La section de connexion 72 comprend une première bordure latérale 74 et une seconde bordure latérale 76 de part et d'autre du connecteur à angle droit 54. Ces deux bordures latérales 74, 76 sont parallèles aux bordures internes 60, 62 de la section principale 32. Ces deux bordures latérales 74, 76 sont séparées des bordures internes 60, 62 par la première fente 56 et la deuxième fente 58.

La section intermédiaire 70 comprend également une première bordure latérale 78 et une seconde bordure latérale 80, ces deux bordures latérales 78, 80 étant parallèles aux bordures internes 60, 62 de la section principale 32. Cependant, les bordures latérales 78, 80 de la section intermédiaire 70 sont plus éloignées des bordures internes 60, 62 que les bordures latérales 74, 76 de la section de connexion 72. Les bordures latérales 78, 80 de la section intermédiaire 70 sont globalement espacées des bordures internes 60, 62 de la même distance.

L'agencement de la section secondaire 34 décrit au travers de la figure 3 n'est pas limitatif. En effet, par exemple, la section secondaire 34 de la carte mère peut également être localisée sur un angle de la carte mère 24. La section secondaire 34 peut également être agencée sur une zone interne au périmètre de la carte mère 24. Dans ces deux exemples, l'inclinaison de la section secondaire 34 relativement à la surface de la section principale 32 est obtenue par l'agencement d'un évidement entourant partiellement la section secondaire 34 et l'agencement d'une frontière 68 délimitant la section secondaire 34 avec la section principale 32.

Selon la figure 4, la carte fille 26, équipée du module de caméra 16, est agencée dans le connecteur à angle droit 54. Plus précisément, l'extrémité de la carte fille 26 insérée dans le connecteur à angle droit 54 comporte des terminaisons électriques (non représentées) par lesquelles des signaux électriques du module de caméra 16 transitent vers les composants électroniques 36 de la carte mère permettant le traitement des images capturées. L'ensemble comportant la carte fille 26 assemblée sur la carte mère 24 représente un dispositif électronique 25 unique du dispositif de caméra 12. L'axe optique AO de l'objectif 30 du module de caméra 16 est perpendiculaire à la carte fille 26. La carte fille 26 est perpendiculaire à la section secondaire 34 de la carte mère 24. La surface de la section secondaire 34 est inclinée d'un angle α relativement à la surface de la section principale 32 selon l'axe de pivotement P. La section intermédiaire 70 a une épaisseur réduite par rapport à l'épaisseur de la section principale. Selon ce mode de réalisation, la section de connexion 72 est de même épaisseur que la section principale 32. La restriction d'épaisseur de la section intermédiaire 70 par rapport à la section principale 32 permet de garantir une inclinaison plus importante qu'à épaisseur équivalente. La section de connexion 72 doit avoir une rigidité suffisante et une épaisseur suffisante pour supporter le poids de la carte fille 26.

Alternativement, la section principale 32 et la section de connexion 72 peuvent avoir des épaisseurs différentes, la section intermédiaire 70 ayant l'épaisseur la plus faible afin de permettre une inclinaison aisée de la section secondaire 34 selon l'axe de pivotement P.

Selon un mode de réalisation particulier, la carte mère 24 est une carte à circuit imprimé comprenant plusieurs couches. De préférence, la section intermédiaire 70 comporte une couche isolante et une couche de cuivre, la section de connexion 72 et la section principale 32 comportant la couche isolante et la couche de cuivre de la section intermédiaire 70 ainsi qu'au moins une couche de cuivre et une couche isolante additionnelles.

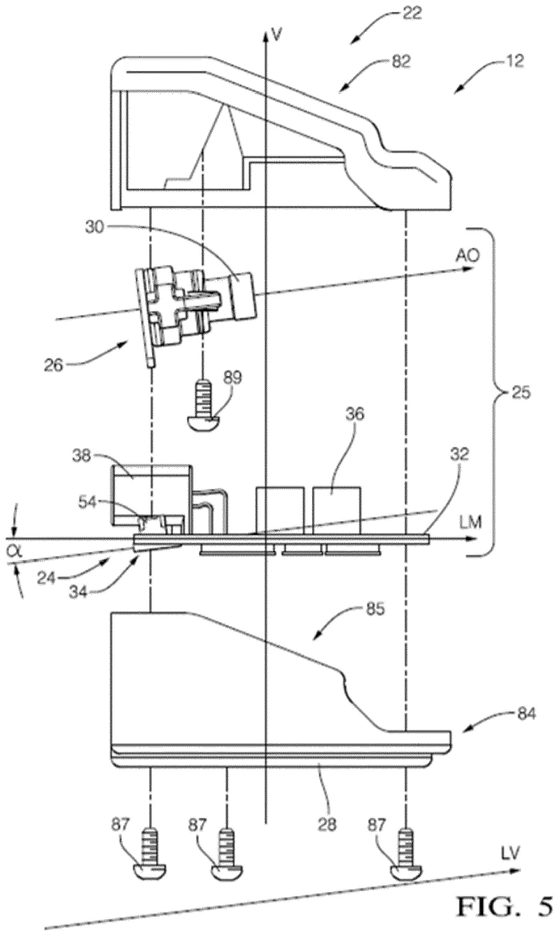

Selon la figure 5, une méthode d'assemblage du dispositif de caméra 12 est représentée. Le dispositif de caméra 12 est pourvu du dispositif électronique 25 comprenant la carte mère 24 assemblée avec la carte fille 26 et l'ensemble boîtier 22.

L'ensemble boîtier 22 comprend deux éléments. Un capot supérieur 82 et un boîtier inférieur 84. Le capot supérieur 82 vient généralement au contact du pare-brise 14 du véhicule 10. Le capot supérieur 82 comprend une ouverture (non représentée) par laquelle l'objectif 30 du module de caméra 16 peut capturer une image du champ de vision 18 du véhicule 10; l'axe optique AO du module de caméra 16 étant parallèle à l'axe longitudinal du véhicule LV.

Le boîtier inférieur 84 est un boîtier comprenant une ouverture supérieure 85 prévue pour être fermer par le capot supérieur 82 et une paroi de fond 28 prévue pour agencer la carte mère 24.

Une première étape d'assemblage consiste à monter les composants électroniques 36 et les connecteurs 38, 54 sur la carte mère 24. Une autre étape consiste à monter le module de caméra 16 sur la carte fille 26 de manière à ce que l'axe optique principal AO soit orthogonal à la surface de la carte fille 26.

L'étape suivante consiste à fixer la carte fille 26 sur le capot supérieur 82, l'objectif 30 du module de caméra 16 étant agencé au travers de l'ouverture. La carte fille 26 est donc solidaire du capot supérieur 82.

Plus particulièrement le module de caméra 16 est fixé par vissage sur le capot supérieur 82 afin de figer l'orientation de l'axe optique AO de sorte que lors du montage du dispositif de caméra 12 sur le pare-brise 14 du véhicule 10, l'axe optique AO soit globalement parallèle à l'axe longitudinal du véhicule LV.

Ensuite, la carte mère 24 est assemblée avec la carte fille 26. Lors de cette étape, il convient d'insérer la carte fille 26 sur la section de connexion 72 de la section secondaire 32. Plus particulièrement, la carte fille 26 est insérée sur le connecteur à angle droit 54, de sorte à être perpendiculaire à la surface de la section de connexion 72.

Enfin, la dernière étape consiste à fermer l'ensemble boîtier 22 en assemblant le boîtier inférieur 84 avec le capot supérieur 82. Lors de cet assemblage, la carte mère 24 est agencée sur la paroi de fond 28 du boîtier inférieur 84. La carte mère est fixée à plat sur la paroi de fond du boîtier inférieur 84 entrainant généralement une inclinaison d'un angle α de la section secondaire 34 de la carte mère 24 relativement à la surface de la section principale 32 selon l'axe de pivotement P. De préférence, telle que représenté sur la figure 5, le module de caméra 16 est fixé par vissage sur le capot supérieur 82. Egalement, la carte mère 24 est fixée à plat sur la paroi de fond 28 du boîtier inférieur 84 par vissage. Les moyens de vissage sont généralement des vis 87, 89. Le serrage des vis 87 maintenant la carte mère à plat sur le fond de boîtier 28 entraine l'inclinaison d'un angle α de la section secondaire 34 de la carte mère 24 relativement à la surface de la section principale 32 selon l'axe de pivotement P.

Le moyen de fixation par vissage n'est pas un moyen limitatif de l'invention. D'autres moyens de fixation peuvent être envisagés, voire combinés entre eux. A titre d'exemple, la carte mère 24 peut être fixée à plat par vissage sur la paroi de fond 28 du boîtier 22, la carte fille 26 venant s'insérer dans un moyen de glissière venue de matière avec le capot supérieur 82. Le moyen de glissière est incliné vis-à-vis de l'axe vertical V de la carte mère 24 afin de figer l'orientation de l'axe optique AO de sorte que lors du montage du dispositif de caméra 12 sur le pare-brise 14 du véhicule 10, l'axe optique AO soit globalement parallèle à l'axe longitudinal du véhicule LV.

Egalement, le connecteur à angle droit 54 n'est pas indispensable. D'autres moyens permettant le contact électrique entre la carte fille 26 et la carte mère 24, telle qu'une insertion en force de l'extrémité de la carte fille 26 comportant des terminaisons électriques au travers la zone de connexion 72 de la section secondaire 34, sont possible.

Une alternative de méthode d'assemblage peut consister à fixer à plat la carte mère 24 sur la paroi de fond 28 du boîtier inférieur 84 avant l'assemblage de la carte mère 24 avec la carte fille 26. Puis d'assembler le boîtier inférieur 84 avec le capot supérieur 82 de manière à fermer l'ensemble boîtier 22, le module de caméra 16 assemblé sur la carte fille 26 ayant été fixé sur le capot supérieur 84 préalablement.

## Revendications

1. Dispositif de caméra (12) comprenant
une carte mère (24) globalement rectangulaire ;
une carte fille (26) comprenant un module de caméra (16) dont l'axe optique (AO) est perpendiculaire au plan principal de la carte fille (26) ;
la carte mère (24) comportant une section principale rigide (32) comprenant des composants électroniques (36) de traitement d'images ;
la carte mère (24) comportant une section secondaire (34) venue de matière avec la section principale (32) ; dispositif dans lequel la section secondaire (34) est partiellement entourée d'un évidement (56, 58);
la section secondaire (34) a une frontière rectiligne (68) délimitant la jonction entre la section principale (32) et la section secondaire (34), la frontière rectiligne (68) définissant un axe de pivotement (P) de la section secondaire (34) ;
la section secondaire (34) comprenant une section de connexion (72) et une section intermédiaire (70) s'étendant entre la frontière rectiligne (68) et la section de connexion (72), la section intermédiaire (70) étant d'épaisseur réduite par rapport à une épaisseur de la section principale (32) ;
la carte fille (26) est montée perpendiculairement sur la section secondaire (34) ainsi rendue inclinable relativement à la surface de la section principale (32) selon l'axe de pivotement (P) pour pouvoir ajuster l'angle d'inclinaison (a) entre l'axe optique (AO) du module de caméra (16) et la section principale (32).

2. Dispositif de caméra (12) selon la revendication 1 dans lequel l'axe optique (AO) est perpendiculaire à l'axe de pivotement (P).

3. Dispositif de caméra (12) selon l'une quelconque des revendications précédentes dans lequel la carte fille (26) est agencée sur la section de connexion (72)
de sorte à pouvoir faciliter l'inclinaison de la section secondaire (34) par rapport à la section principale (32).

4. Dispositif de caméra (12) selon la revendication 3 dans lequel la section intermédiaire (70) a une épaisseur réduite par rapport à l'épaisseur de la section de connexion (72).

5. Dispositif de caméra (12) selon l'une quelconque des revendications précédentes dans lequel la section secondaire (34) est délimitée par au moins une fente (56) s'étendant depuis un bord rectiligne de la carte mère (24) jusqu'à l'axe de pivotement (P) de la section secondaire (34).

6. Dispositif de caméra (12) selon la revendication 5 dans lequel la section secondaire (34) est délimitée par deux fentes (56, 58) de part et d'autre de la section secondaire (34), les deux fentes (56, 58) s'étendant depuis le bord rectiligne de la carte mère (24) jusqu'à l'axe de pivotement (P) de la section secondaire (34).

7. Dispositif de caméra de caméra (12) selon l'une quelconque des revendications précédentes configuré pour être monté dans le compartiment passager d'un véhicule (10), sur le pare-brise (14) du véhicule (10), **caractérisé en ce que** le dispositif de caméra (12) comporte :
un ensemble boîtier (22) comprenant une paroi de fond (28) et un capot supérieur (82) ;
la carte mère (24) fixée à plat sur la paroi de fond (28) du boîtier (22);
le module de caméra (16) fixé sur le capot supérieur (82) ; de sorte que la section secondaire (34) de la carte mère (24) est inclinée d'un angle α relativement à la surface de la section principale (32) selon l'axe de pivotement (P).

8. Méthode d'assemblage d'un dispositif de caméra (12) comportant les étapes de fourniture d'une carte mère (24) globalement rectangulaire comportant une section principale rigide (32) et une section secondaire (34) partiellement entourée d'un évidement (56, 58) et ayant une frontière rectiligne (68) délimitant une jonction entre la section principale (32) et la section secondaire (34), la frontière rectiligne (68) définissant un axe de pivotement (P) de la section secondaire (34) de manière que la section secondaire (34) soit inclinable relativement à la surface de la section principale (32) selon l'axe de pivotement (P);
réalisation d'une section de connexion (72) et d'une section intermédiaire (70) sur la section secondaire (34) prévue pour connecter une carte fille (26), ladite section intermédiaire (70) s'étendant entre la frontière rectiligne (68) et la section de connexion (72) et étant d'épaisseur réduite par rapport à une épaisseur de la section principale (32) ;
fourniture d'une carte fille (26) comprenant un module de caméra (16) dont l'axe optique (AO) est perpendiculaire au plan principal de la carte fille (26) ;
fourniture d'un ensemble boîtier (22) comportant un capot supérieur (82) et un boitier inférieur (84) ;
fixation du module de caméra (16) sur le capot supérieur (82) ;
assemblage de la carte mère (24) sur la carte fille (26) par connexion de la carte fille (26) orthogonalement sur la section de connexion (72) ;
assemblage du boîtier inférieur (84) avec le capot supérieur (82) de sorte à fermer l'ensemble boîtier (22);
fixation à plat de la carte mère (24) sur la paroi de fond (28) du boîtier inférieur (84), l'axe optique (AO) du module de caméra (16) s'inclinant d'un angle α relativement à la surface de la section principale (32) de la carte mère (24).

9. Méthode d'assemblage du dispositif de caméra (12) selon la revendication 8 dans laquelle les étapes de fixation de la carte mère (24) et du module de caméra (16) se font par vissage.

## Patentansprüche

1. Kameravorrichtung (12), die umfasst:
eine allgemein rechtwinklige Hauptplatine (24);
eine Tochterplatine (26), die ein Kameramodul (16) umfasst, dessen optische Achse (AO) senkrecht zur Hauptebene der Tochterplatine (26) ist;
wobei die Hauptplatine (24) einen starren Hauptabschnitt (32) umfasst, der elektronische Bauteile (36) zur Verarbeitung von Bildern umfasst;
wobei die Hauptplatine (24) einen Nebenabschnitt (34) umfasst, der mit dem Hauptabschnitt (32) einstückig ist;
wobei in der Vorrichtung der Nebenabschnitt (34) teilweise von einer Aussparung (56, 58) umgeben ist;
der Nebenabschnitt (34) eine geradlinige Grenze (68) aufweist, die die Verbindung zwischen dem Hauptabschnitt (32) und dem Nebenabschnitt (34) abgrenzt, wobei die geradlinige Grenze (68) eine Schwenkachse (P) des Nebenabschnitts (34) definiert;
der Nebenabschnitt (34) einen Verbindungsabschnitt (72) und einen Zwischenabschnitt (70) umfasst, der sich zwischen der geradlinigen Grenze (68) und dem Verbindungsabschnitt (72) erstreckt, wobei der Zwischenabschnitt (70) eine im Verhältnis zu einer Dicke des Hauptabschnitts (32) verminderte Dicke aufweist;
die Tochterplatine (26) senkrecht an dem so in Bezug auf die Oberfläche des Hauptabschnitts (32) entlang der Schwenkachse (P) neigbar gemachten Nebenabschnitt (34) montiert ist, um den Neigungswinkel (a) zwischen der optischen Achse (AO) des Kameramoduls (16) und dem Hauptabschnitt (32) anpassen zu können.

2. Kameravorrichtung (12) nach Anspruch 1, wobei:
die optische Achse (AO) senkrecht zur Schwenkachse (P) ist.

3. Kameravorrichtung (12) nach einem der vorhergehenden Ansprüche, wobei die Tochterplatine (26) derart auf dem Verbindungsabschnitt (72) eingerichtet ist, dass die Neigung des Nebenabschnitts (34) in Bezug auf den Hauptabschnitt (32) erleichtert werden kann.

4. Kameravorrichtung (12) nach Anspruch 3, wobei der Zwischenabschnitt (70) eine im Verhältnis zur Dicke des Verbindungsabschnitts (72) verminderte Dicke aufweist.

5. Kameravorrichtung (12) nach einem der vorhergehenden Ansprüche, wobei der Nebenabschnitt (34) durch mindestens einen Schlitz (56) abgegrenzt ist, der sich ausgehend von einem geradlinigen Rand der Hauptplatine (24) bis zur Schwenkachse (P) des Nebenabschnitts (34) erstreckt.

6. Kameravorrichtung (12) nach Anspruch 5, wobei der Nebenabschnitt (34) durch zwei Schlitze (56, 58) auf beiden Seiten des Nebenabschnitts (34) begrenzt ist, wobei die zwei Schlitze (56, 58) sich von dem geradlinigen Rand der Hauptplatine (24) bis zur Schwenkachse (P) des Nebenabschnitts (34) erstrecken.

7. Kameravorrichtung (12) nach einem der vorhergehenden Ansprüche, die ausgestaltet ist, um in der Fahrgastzelle eines Fahrzeugs (10) an der Windschutzscheibe (14) des Fahrzeugs (10) montiert zu werden, **dadurch gekennzeichnet, dass** die Kameravorrichtung (12) umfasst:
eine Gehäusebaugruppe (22), die eine Rückwand (28) und eine obere Haube (82) umfasst;
die flach an der Rückwand (28) des Gehäuses (22) befestigte Hauptplatine (24);
das an der oberen Haube (82) befestigte Kameramodul (16); derart, dass der Nebenabschnitt (34) der Hauptplatine (24) mit einem Winkel α in Bezug auf die Oberfläche des Hauptabschnitts (32) entlang der Schwenkachse (P) geneigt ist.

8. Verfahren zur Montage einer Kameravorrichtung (12), das die folgenden Schritte umfasst:
Bereitstellen einer allgemein rechtwinkligen Hauptplatine (24), die einen starren Hauptabschnitt (32) und einen Nebenabschnitt (34) umfasst, der teilweise von einer Aussparung (56, 58) umgeben ist und eine geradlinige Grenze (68) aufweist, die eine Verbindung zwischen dem Hauptabschnitt (32) und dem Nebenabschnitt (34) abgrenzt, wobei die geradlinige Grenze (68) eine Schwenkachse (P) des Nebenabschnitts (34) definiert, derart dass der Nebenabschnitt (34) in Bezug auf die Oberfläche des Hauptabschnitts (32) entlang der Schwenkachse (P) schwenkbar ist;
Ausführen eines Verbindungsabschnitts (72) und eines Zwischenabschnitts (70) auf dem Nebenabschnitt (34), der vorgesehen ist, um eine Tochterplatine (26) zu verbinden, wobei der Zwischenabschnitt (70) sich zwischen der geradlinigen Grenze (68) und dem Verbindungsabschnitt (72) erstreckt und eine im Verhältnis zu einer Dicke des Hauptabschnitts (32) verminderte Dicke aufweist;
Bereitstellen einer Tochterplatine (26), die ein Kameramodul (16) umfasst, dessen optische Achse (AO) senkrecht zur Hauptebene der Tochterplatine (26) ist;
Bereitstellen einer Gehäusebaugruppe (22), die eine obere Haube (82) und ein unteres Gehäuse (84) umfasst;
Befestigen des Kameramoduls (16) auf der oberen Haube (82) ;
Montieren der Hauptplatine (24) an der Tochterplatine (26) durch Verbinden der Tochterplatine (26) orthogonal mit dem Verbindungsabschnitt (72);
Montieren des unteren Gehäuses (84) an der oberen Haube (82), derart, dass die Gehäusebaugruppe (22) geschlossen wird;
flaches Befestigen der Hauptplatine (24) an der Rückwand (28) des unteren Gehäuses (84), wobei die optische Achse (AO) des Kameramoduls (16) sich mit einem Winkel α in Bezug auf die Oberfläche des Hauptabschnitts (32) der Hauptplatine (24) neigt.

9. Verfahren zur Montage einer Kameravorrichtung (12) nach Anspruch 8, wobei die Schritte zum Befestigen der Hauptplatine (24) und des Kameramoduls (16) durch Schrauben erfolgen.

## Claims

1. A camera device (12) comprising:
a generally rectangular motherboard (24);
a daughterboard (26) comprising a camera module (16) whose optical axis (AO) is perpendicular to the main plane of the daughterboard (26);
the motherboard (24) including a rigid main section (32) comprising electronic image processing components (36);
the motherboard (24) including a secondary section (34) integrally formed with the main section (32);
device wherein
the secondary section (34) is partially surrounded by a recess (56, 58);
the secondary section (34) has a straight boundary (68) delimiting the junction between the main section (32) and the secondary section (34), the straight boundary (68) defining a pivot axis (P) of the secondary section (34);
the secondary section (34) comprising a connection section (72) and an intermediate section (70) extending between the straight boundary (68) and the connection section (72), the intermediate section (70) being of reduced thickness relative to a thickness of the main section (32);
the daughterboard (26) is perpendicularly mounted on the secondary section (34) thus made tiltable relative to the surface of the main section (32) along the pivot axis (P) to be able to adjust the tilt angle (α) between the optical axis (AO) of the camera module (16) and the main section (32).

2. The camera device (12) according to claim 1 wherein
the optical axis (AO) is perpendicular to the pivot axis (P) .

3. The camera device (12) according to any one of the preceding claims wherein the daughterboard (26) is arranged on the connection section (72) so as to be able to facilitate the tilting of the secondary section (34) relative to the main section (32).

4. The camera device (12) according to claim 3 wherein the intermediate section (70) has a reduced thickness compared to the thickness of the connection section (72).

5. The camera device (12) according to any one of the preceding claims wherein the secondary section (34) is delimited by at least at one slot (56) extending from a straight edge of the motherboard (24) to the pivot axis (P) of the secondary section (34).

6. The camera device (12) according to claim 5 wherein the secondary section (34) is delimited by two slots (56, 58) on either side of the secondary section (34), the two slots (56, 58) extending from the straight edge of the motherboard (24) to the pivot axis (P) of the secondary section (34).

7. The camera device (12) according to any one of the preceding claims configured to be mounted in the compartment passenger of a vehicle (10), on the windshield (14) of the vehicle (10), **characterized in that** the camera device (12) includes:
a casing assembly (22) comprising a bottom wall (28) and an upper cover (82);
the motherboard (24) fixed flat on the bottom wall (28) of the casing (22);
the camera module (16) fixed on the upper cover (82); so that the secondary section (34) of the motherboard (24) is tilted at an angle α relative to the surface of the main section (32) along the pivot axis (P).

8. A method for assembling a camera device (12) including the steps of:
providing a generally rectangular motherboard (24) including a rigid main section (32) and a secondary section (34) partially surrounded by a recess (56, 58) and having a straight boundary (68) delimiting a junction between the main section (32) and the secondary section (34), the straight boundary (68) defining a pivot axis (P) of the secondary section (34) so as the secondary section (34) is tiltable relative to the surface of the main section (32) along the pivot axis (P);
making a connection section (72) and an intermediate section (70) on the secondary section (34) provided to connect a daughterboard (26), said intermediate section (70) extending between the straight boundary (68) and the connection section (72) and being of reduced thickness compared to a thickness the main section (32);
providing a daughterboard (26) comprising a camera module (16) whose optical axis (AO) is perpendicular to the main plane of the daughterboard (26);
providing a casing assembly (22) including an upper cover (82) and a lower casing (84);
fixing the camera module (16) on the upper cover (82);
assembling the motherboard (24) on the daughterboard (26) by connection of the daughterboard (26) orthogonally to the connection section (72);
assembling the lower casing (84) with the upper cover (82) so as to close the casing assembly (22);
fixing flat the motherboard (24) on the bottom wall (28) of the lower casing (84), the optical axis (AO) of the camera module (16) tilting at an angle α relative to the surface of the main section (32) of the motherboard (24).

9. The method for assembling the camera device (12) according to claim 8 wherein the steps of fixing the motherboard (24) and the camera module (16) are made by screwing.
